# EUROPEAN PATENT APPLICATION

(11) **EP 2 138 603 A1**
(43) Date of publication of application: **30.12.2009**
(21) Application number: 08738991.2
(22) Date of filing: 27.03.2008
(51) Int. Cl.: C23C 14/32, H05H 1/32

(54) **PLASMA GENERATION EQUIPMENT RENDERED ELECTRICALLY NEUTRAL ON THE PERIPHERY OF PLASMA GUN**

(30) Priority: 30.03.2007 JP 2007093356
(71) Applicant: Ferrotec Corporation, Chuo-ku Tokyo 1040031 (JP)
(72) Inventor: SHIINA, Yuichi, Tokyo 104-0031 (JP)
(74) Representative: Schickedanz, Willi
(86) International application number: PCT/JP2008/055841
(87) International publication number: WO 2008/120656

(57) **Abstract**

There is provided a plasma generating apparatus having a plasma gun which can remove droplets mixed with plasma efficiently without reducing the effective amount of plasma generated by vacuum arc discharge and in which a droplet removing portion can be constituted easily and inexpensively, and precision of surface treatment of films by high purity plasma can be enhanced. Periphery of a cathode (407) of said plasma gun is surrounded by an enclosure member (420) and a droplet removing device (406) constituted by laying a plurality of droplet collecting members (411) in multilayer is provided on the inside of the enclosure member (420). The enclosure member (420), the collecting member (411) and a plasma advancing path (402) have no relation connected with an arc power supply (409) and are held in an electrically neutral floating state.

## Description

### FIELD OF THE INVENTION

The present invention relates to a plasma generating apparatus installed with a droplet eliminating portion by which a plasma is generated by a vacuum arc discharge performed in an arc discharge portion set under a vacuum atmosphere and cathode material particles (referred to as droplets) by-produced from a cathode at a plasma generating time can be removed.

### BACKGROUND ART

In general, it is known that thin film is formed on the surface of solid material in plasma and a solid surface characteristic is improved by injecting ions. Film formed by using of plasma including metal ion and metalloid ion can strengthen the characteristics of abrasion resistance and corrosion resistance of a solid surface, so that its film is useful as protective film, optical thin film and transparent conductivity film. In particular, the carbon film using carbon plasma is a diamond-like-carbon film (referred to as DLC film) comprising an amorphous conglomerate of diamond structure and graphite structure, so that it has a high utility value.

As an approach to generate plasma including metal ion and metalloid ion, there is provided a vacuum arc plasma method. A vacuum arc plasma is formed by an arc discharge generated between cathode and anode, namely after a cathode material evaporates from a cathode spot existing on the cathode surface, the plasma is formed by this cathode evaporation material. In addition, when a reactive gas and/or an inert gas (rare gas) were introduced as ambient atmosphere gas, the reactive gas and/or the inert gas also are ionized at the same time. By performing the thin film formation and the ion injection on solid surface by means of such a plasma, surface treatment process can be carried out.

Generally, in the vacuum arc discharge, vacuum arc plasma constituent particles such as cathode material ion, electron and cathode material neutral particle (atom and molecule) are emitted from the cathode spot, and at the same time, the cathode material fine particles referred to as droplets of size of less than sub-micron to several hundred micron (0.01 - 1000 µm) are also emitted. However, a problem appeared in surface treatment such as a filming is the generation of droplet. When said droplets bond on the object surface to be treated, the uniformity of thin film formed on said object surface to be treated is lost, and it becomes the defect product of thin film.

As a method to solve above problem of droplets, there is described a magnetic filter method (P.J. Martin, R. P. Netterfield and T.J. Kinder, Thin Solid Films 193/194 (1990) 77) (non-patent document 1). This magnetic filter method transports said vacuum arc plasma to a treating portion through a curved droplet collecting duct. According to this method, the emitted droplets are adhesion-captured (collected) on an inner circumferential wall of said duct, so that there is obtained the plasma flow that hardly includes the droplets at the duct exit. In addition, curved magnetic field is formed by means of magnet disposed along the duct, and the plasma stream is bent by said curved magnetic field, so that plasma P is effectively guided to a plasma processing portion.

Japanese Patent Laid-Open No. 2002-8893 (patent document 1) discloses a plasma processing apparatus including a droplet collecting portion. FIG. 13 is a schematic outlined diagram of conventional plasma processing apparatus. In plasma generating portion 102, the electricity spark is occurring between cathode 104 and trigger electrode 106, and the vacuum arc is generated between cathode 104 and anode 108, so that the plasma 109 is generated. In the plasma generating portion 102, the power source 110 is connected to generate the electricity spark and the vacuum arc discharge, and the plasma stabilizing magnetic field generators 116a, 116b are disposed to stabilize the plasma 109. The plasma 109 is guided from the plasma generating portion 102 to the plasma processing portion 112, and the object 114 to be treated being arranged in the plasma processing portion 112 is receiving the surface treatment by the plasma 109. Additionally, the reactivity gas is introduced as necessary by the gas introduction system Gt connected to the plasma processing portion 112 and the reaction gas and the plasma flow are exhausted by the gas exhaust system Gh.

The plasma 109 emitted from the plasma generating portion 102 is bent in the direction which is not facing the plasma generating portion 102 by the magnetic field and the plasma flows into the plasma processing portion 112. At the position facing the plasma generating portion 102, there is disposed a droplet collecting portion 120 by which the cathode material fine particles (droplets) by-produced from the cathode at the generating time of plasma 109 are collected. Therefore, the droplets 118 not affected by the magnetic field advance to the droplet collecting portion 120 and are collected by it, so that it is prevented that the droplets 118 penetrate into the plasma processing portion 112.
[Patent Document 1] Japanese Patent Laid-Open No. 2002-8893
[Non-Patent Document 1] P.J. Martin, R.P. Netterfield and T.J. Kinder, Thin Solid Films 193/194 (1990) 77.

### DISCLOSURE OF THE INVENTION

### PROBLEM TO BE SOLVED BY THE INVENTION

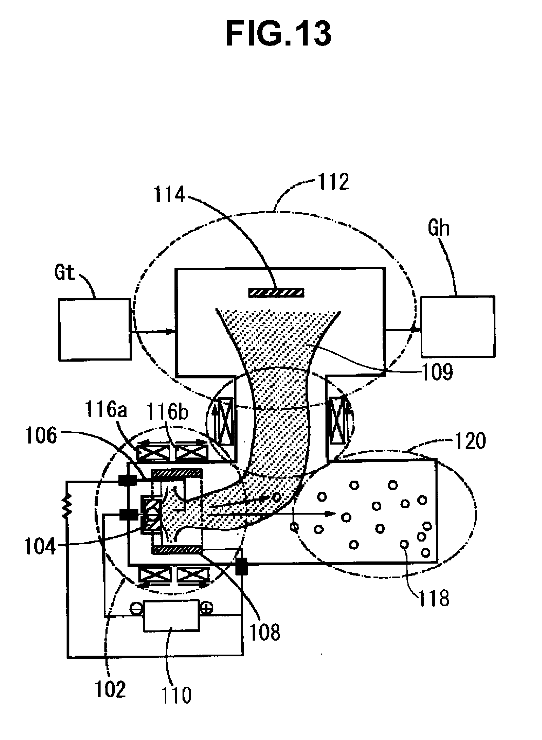

In a conventional plasma processing apparatus shown in FIG. 13, the droplets 118 which do not receive the effect of said magnetic field are collected by the droplet collecting portion 120, but there was the case that the charged droplets in which electric charge was given by interaction with plasma 109 were guided to the plasma processing portion 112 by the magnetic field. Furthermore, the droplets of small particle size which are not collected by the droplet collecting portion 120 are accompanied by plasma flow and guided to the plasma processing portion 112. Therefore, since the droplets are mixed with plasma flow without being collected such as charged droplets and small droplets bond on the object surface to be treated, the uniformity of thin film formation and surface modification on said object surface to be treated is lost, and the surface property of the object to be treated decreases.

Besides, in the magnetic filter method disclosed in non-patent document 1, as described above, since the plasma flow is bent by the curved magnetic field and the plasma moves efficiently to the plasma processing portion, the charged droplets and small droplets mixed with the plasma flow are guided to the plasma processing portion without being removed, so that it can not be prevented that they collide or bond on the object surface to be treated.

In recent plasma filming technology, the filming using of various kinds of material has been provided, and the improvement of filming precision such as smoothness due to the filming apparatus is demanded. As described above, since the droplet bond strongly affects to the filming precision, improvement of droplet removing efficiency in plasma generating apparatus is needed. In addition, as shown in FIG.13, when many magnetic field generators for droplet removal are installed, complexity of apparatus occurs and there was a problem to bring about increase in cost for apparatus and filming treatment.

From the test results relating to droplet removal in the plasma generating apparatus using the vacuum arc discharge, the present inventor brought about the knowledge that the droplets contained in the plasma can be collected by colliding and absorbing them on ribs when said rib (protrusion member) is disposed on the inner wall of the plasma flowing path. Moreover, on the basis of the knowledge of the present inventor, since the more droplets scatter in said plasma generating portion, the attention was paid to the possibility that the effective droplet removal is performed when the ribs are disposed in said plasma generating portion.

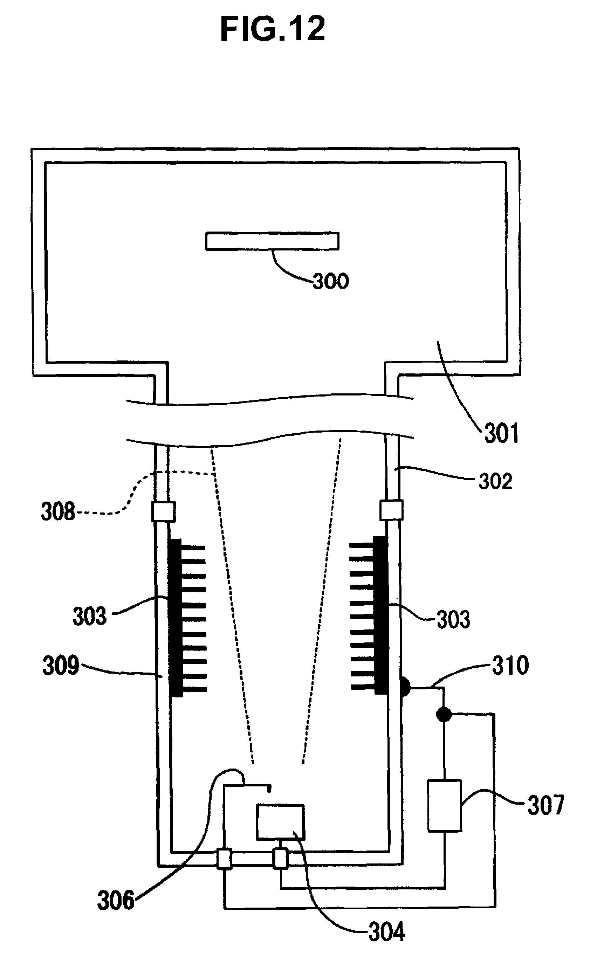

FIG.12 shows a plasma generating apparatus in which a plurality of ribs 303 are arranged in multilayer as collecting member in a plasma generating portion. The plasma generating portion is constituted from an arc power supply 307 and a plasma gun constructed by a cathode 304, a trigger electrode 306 and a housing 309, and the housing 309 made by electroconductive material becomes an anode by connecting it to the arc power supply 307 through a connection cable. Said housing 309 is connected to a plasma flowing path 302, a plasma 308 generated by said plasma gun is introduced to a plasma processing portion 301 through the plasma flowing path 302 so as to be irradiated to an object 300 to be plasma-treated, and a plurality of ribs 303 are installed on the inner wall of said housing 309. It is preferable that the ribs 303 are formed from the same electroconductive material as cathode 304, so that the purity of plasma can be held even though ions are generated by thermal emission based upon temperature rise of the ribs 303 at the plasma generating time.

However, in the plasma generating apparatus in which the ribs 303 are disposed on the inner wall of the housing 309 constructing the outer wall of said plasma gun, the following problem existed. The plasma 308 is generated by the vacuum arc discharge between cathode 304 and anode of housing 309, and is emitted towards the plasma processing portion 301. As described above, since the ribs 303 are formed by the same electroconductive material as cathode 304, housing 309 and the ribs 303 are electrically conductive each other, so that the ribs 303 have the positive potential. That is to say, though the droplet removing effect is obtained by said ribs, the housing 309 becomes anode, so that many electrons in plasma 308 generated at cathode 304 are attracted to said ribs 303 near cathode 304, then the electrical discharge was induced between the ribs and cathode 304. When such a discharge generates, energy loss occurs and stability is lost, so that there was a problem that the quantity of plasma generated from cathode 304 reduces.

Therefore, the purpose of the present invention is not to reduce the effective quantity of plasma generated by vacuum arc discharge in said plasma gun, to remove efficiently droplets mixed in the plasma generated, to constitute the droplet removing portion easily and cheaply, and to present the plasma generating apparatus by which the surface treating precision such as filming can be improved by using of high purity plasma.

### MEANS TO SOLVE THE PROBLEM

The present invention is proposed to solve the above problems. In a plasma generating apparatus including a plasma generating portion by which a plasma is generated by a vacuum arc discharge occurred between a cathode and an anode under a vacuum atmosphere and a plasma advancing path in which said plasma generated by said plasma generating portion progresses to a plasma treating portion side, the first form of the present invention is said plasma generating apparatus **characterized in that** an enclosure member surrounding the periphery of said cathode is arranged in said plasma generating portion, a collecting member catching cathode material particles (referred to as droplets) by-produced from said cathode at a plasma generating time is disposed on the inside of said enclosure member, and at least said collecting member and said enclosure member are held in an electrically neutral floating state.

The second form of the present invention is, in said first form, the plasma generating apparatus, wherein a plurality of said collecting members are disposed in multilayer on the inside of said enclosure member around said cathode and along a progressing direction of said plasma.

The third form of the present invention is, in said second form, the plasma generating apparatus, wherein said collecting member is constituted by an annular member in which a hollow portion is formed to flow said plasma, and a plurality of said annular members of the same shape are disposed in multilayer.

The fourth form of the present invention is, in said second form, the plasma generating apparatus, wherein a plurality of said collecting members include the annular members of which size of said hollow portion is different and a plurality of said annular members are disposed in multilayer so as that the size of each hollow portion increases gradually.

The fifth form of the present invention is, in any one of said first to fourth forms, the plasma generating apparatus, wherein a duct portion forming said plasma advancing path is set to be in the electrically neutral floating state.

The sixth form of the present invention is, in any one of said first to fifth forms, the plasma generating apparatus, wherein said anode is an annular electrode disposed to be electrically insulated from said enclosure member and an inner diameter of said annular electrode decreases along an advancing direction of plasma.

The seventh form of the present invention is, in any one of said first to sixth forms, the plasma generating apparatus, wherein a droplet removing portion removing said droplets is disposed in said plasma advancing path, and said plasma removing portion includes a radially enlarged tube, an introduction side radially reduced tube connected to a plasma introducing side initial end of said radially enlarged tube, a discharge side radially reduced tube connected to a plasma discharge side terminal end of said radially enlarged tube, and stepped portions formed at said initial end and said terminal end of said radially enlarged tube.

The eighth form of the present invention is, in said seventh form, the plasma generating apparatus, wherein tube axes of said introduction side radially reduced tube and/or said discharge side radially reduced tube are inclinedly disposed for a tube axis of said radially enlarged tube, and said introduction side radially reduced tube and/or said discharge side radially reduced tube are connected to said radially enlarged tube.

The ninth form of the present invention is, in said seventh or eighth form, the plasma generating apparatus, wherein said tube axes of said introduction side radially reduced tube and said discharge side radially reduced tube are disposed so as to intersect each other.

The tenth form of the present invention is, in said seventh, eighth or ninth form, the plasma generating apparatus, wherein said plasma advancing path includes a straightly advancing tube connected to said plasma generating portion, said introduction side radially reduced tube is connected vertically or almost vertically to said straightly advancing tube, and a droplet collecting portion is disposed at a terminal end of said straightly advancing tube.

The eleventh form of the present invention is, in any one of said seventh to tenth forms, the plasma generating apparatus, wherein said radially enlarged tube is composed of an inner circumferential tube and an outer circumferential tube, and said inner circumferential tube is freely inserted to and removed from said outer circumferential tube.

The twelfth form of the present invention is, in said eleventh form, the plasma generating apparatus, wherein a plurality of droplet collecting plates are installed on an inner wall of said inner circumferential tube.

The thirteenth form of the present invention is, in said twelfth form, the plasma generating apparatus, wherein a rough surface processing is made on a surface of said droplet collecting plate.

The 14th form of the present invention is, in said twelfth form, the plasma generating apparatus, wherein said droplet collecting plates are inclinedly disposed for said introduction side radially reduced tube.

The 15th form of the present invention is, in any one of said seventh to 14th forms, the plasma generating apparatus, wherein an aperture for collecting the droplets is arranged in said introduction side radially reduced tube and said discharge side radially reduced tube.

The 16th form of the present invention is, in any one of said fifth to thirteenth forms, the plasma generating apparatus, wherein a plurality of said radially enlarged tubes are connected through a radially reduced tube.

The 17th form of the present invention is, in any one of said seventh to 16th forms, the plasma generating apparatus, wherein said introduction side radially reduced tube, said radially enlarged tube and said discharge side radially reduced tube are electrically insulated with said plasma generating portion and said plasma treating portion.

The 18th form of the present invention is, in any one of said seventh to 17th forms, the plasma generating apparatus, wherein a quantity of physical property of plasma is measured by inserting a probe into a duct portion including at least said introduction side radially reduced tube, said radially enlarged tube and said discharge side radially reduced tube or by utilizing said duct portion as said probe.

The 19th form of the present invention is, in any one of said first to 18th forms, the plasma generating apparatus, wherein one or combination of effective total length, diameter, bending number and summation of bending angle in said plasma advancing path is set so as to satisfy a droplet reduction condition.

The 20th form of the present invention is, in said 19th form, the plasma generating apparatus, wherein said effective total length is set at 900 - 1600 mm.

The 21 st form of the present invention is, in said 19th form, the plasma generating apparatus, wherein said diameter is set at 90 - 200 mm.

The 22nd form of the present invention is, in said 19th form, the plasma generating apparatus, wherein said bending number is set at 3 - 1.

The 23rd form of the present invention is, in said 19th form, the plasma generating apparatus, wherein said summation of bending angle is set at 90 - 150°.

The 24th form of the present invention is, in said 19th form, the plasma generating apparatus, wherein an arc current value in said plasma generating portion is adjusted in a range of 30 - 140 A.

### EFFECT OF THE INVENTION

According to the first form of the present invention, since said plasma generating portion includes the enclosure member surrounding the periphery of said cathode, the collecting member catching the droplets by-produced from said cathode is disposed on the inside of said enclosure member, and at least said enclosure member and said collecting member are held in an electrically neutral floating state, said plasma collides with said enclosure member and said collecting member, so that it is suppressed that the transporting efficiency of plasma deteriorates. In addition, it is possible to remove them by adhering and removing said droplets scattered to the periphery of said cathode on said collecting member with high efficiency. In other words, the electrical discharge phenomena do not occur in the case of droplet removal due to said collecting member and the energy loss does not generate. By this, since said collecting member can be installed in proximity to said plasma gun, it is possible to remove the droplets with high efficiency and to send out the plasma with high purity and high energy to said plasma advancing path.
As said collecting member (also called "catching member") is held at the electrically neutral floating state, it can be formed from the same material as the anode. Additionally, in the case that said collecting member is formed from the same material as the cathode, even if the ions are thermally emitted from the surface by the temperature rise of said collecting member at the plasma generating time, the purity of plasma can be held because it is the same material as ions in the plasma. For example, in the case that the cathode is constituted from carbon material, when said collecting member is formed from the same carbon material, the same carbon is ionized even in the case that some abnormal discharge occurred on the portion of said collecting member, so that they do not become impure even if they are transported and filmed on the object to be plasma-treated with plasma. However, when the collecting member except product is used, they become impure. Still, said collecting member may be formed from material different to the cathode and anode materials, and it is possible to select the optimum material without distinction of electroconductive substance (W, Mo, Ta, Fe, Al, Cu or stainless steel) and non-conductive substance (ceramics etc).
Furthermore, in the case that the bias voltage is applied to said plasma advancing path, when said enclosure member is connected to the initial end of said plasma advancing path through the insulator, it is possible to hold said enclosure member at the electrically neutral floating state. Moreover, it is more preferable that said plasma advancing path is set at the electrically neutral floating state, so that it is possible to suppress the decay of plasma in said plasma advancing path and to increase the transportation efficiency of plasma.

According to the second form of the present invention, since a plurality of said collecting members are disposed in multilayer on the inside of said enclosure member around said cathode and along the advancing direction of said plasma, the collectable area of droplet becomes large and it is possible to increase the removing efficiency of droplet. Since the droplets not only straightly advance only in the plasma advancing direction but also scatter to the periphery of said cathode by rebounding backwards after colliding with the inner wall of said enclosure member, it is preferable that said collecting member is also disposed at back and side of said cathode. That is to say, when said collecting member is disposed in multilayer in the whole area around the cathode including the back, it is possible to catch the droplets dispersing to the back and the side of the cathode, and to prevent that the droplets which rebound to the front are mixed with the plasma flow.

According to the third form of the present invention, said collecting member is constituted by an annular member in which a hollow portion is formed in order to let said plasma flow and a plurality of said annular members of the same shape are disposed in multilayer. For example, by using of a plurality of collecting members of hollow ring type and by disposing them in multilayer with a predetermined interval on the inner wall of said enclosure member, it is possible to enhance the droplet removal efficiency based upon enlargement of collectable area of droplets and to feed the high purity plasma in which droplets were removed with high efficiency to the plasma advancing path side smoothly through the hollow portion of each collecting member.

According to the fourth form of the present invention is, a plurality of said collecting members include the annular members of which size of said hollow portion is different and a plurality of said annular members are disposed in multilayer so as that the size of each hollow portion increases gradually. For example, each collecting member has the ring type shape, and by using a plurality of collecting members of which size of hollow portion gradually increases and by disposing each member in order of size of each hollow portion toward the plasma advancing space of said cathode front in multilayer with a predetermined interval on the inner wall of said enclosure member, it is possible to enhance the droplet removal efficiency based upon enlargement of collectable area of droplets. Since there is formed the plasma advancing space in which the hollow portions of each ring are disposed like reverse truncated cone geometry from said cathode to the front, it is possible to decrease the rate that the generated plasma emitted in the shape of about cone from said cathode to the front collides with said collecting member while removing the droplets with high efficiency, and it is possible to advance the high purified plasma smoothly through said plasma advancing space, so that the efficient utilization of the generated plasma can be performed.
Further, the form of the collecting member in the present invention is not limited to said ring form, and it may be anti-annular form such as platelet-shaped form and protrusion-shaped form, and in the case of anti-annular form, they are used so as to be disposed radially and convexly on the inner wall of said enclosure member.

According to the fifth form of the present invention, since the duct portion forming said plasma advancing path is set to be in the electrically neutral floating state, it is possible to suppress the deterioration of plasma transportation efficiency because it is prevented that the energy loss occurs based upon plasma collision on the inner surface of said duct portion. In addition, the plasma advancing path means the path from plasma generating portion to plasma treating portion (including plasma processing portion) along which the plasma is induced. In general, the plasma advancing path is constituted from the duct portion in which the magnetic generator guiding the plasma by electromagnetic interaction is arranged one or more, and the function of filter tube removing droplets is given.

According to the sixth form of the present invention, since said anode is an annular electrode disposed to be electrically insulated from said enclosure member and an inner diameter of said annular electrode decreases along an advancing direction of plasma, the generated plasma is guided to the plasma advancing path with high efficiency, and it has also the function of aperture, so that it is possible to suppress that the droplets ingress into the plasma advancing path.

According to the seventh form of the present invention, since said plasma removing portion disposed in said plasma advancing path includes a radially enlarged tube, an introduction side radially reduced tube connected to a plasma introducing side initial end of said radially enlarged tube, a discharge side radially reduced tube connected to a plasma discharge side terminal end of said radially enlarged tube, and stepped portions formed at said initial end and said terminal end of said radially enlarged tube, the plasma flow derived from said introduction side radially reduced tube to said radially enlarged tube is diffused by the radially enlarging action of said plasma advancing path based on said radially enlarged tube. By the diffusion of said plasma flow, as the droplets mixing in said plasma diffuse in said radially enlarged tube, the droplets collide with neighborhood of said stepped portion and the inner side wall of said radially enlarged tube and are recovered. In addition, when the plasma flow existing in said radially enlarged tube is egested, the droplets scattering to the inner wall surface of said radially enlarged tube collide with said stepped portion by the radially reducing action from said radially enlarged tube to said discharge side radially reduced tube, so that the droplets bond and recovered on said stepped portion, and the re-mixing of droplets can be prevented without being joined to the plasma flow.
Therefore, by bonding the droplets in the neighborhood of said stepped portion and the inner side wall of said radially enlarged tube, they are fully recovered, so that it is possible to remove efficiently the droplets in said plasma advancing path. Moreover, when the center axes do not coincide with the center among the radially enlarged tube and the introduction side radially reduced tube and/or the discharge side radially reduced tube, it becomes easy to separate the droplets from the plasma flow and the collecting efficiency of droplets becomes higher. Besides, by forming said radially enlarged tube in said plasma advancing path, it is possible to construct the droplet removing portion easily and cheaply, and the precision of surface treatment such as filming is improved by using of the high purity plasma obtained by improvement of droplet removing efficiency, so that it is possible to improve surface modification of the object surface to be treated and uniformity of the formed film still more.
Still, in said radially enlarged tube, a rotational magnetic field applying means generating a rotational magnetic field in a cross section circumferential direction of this radially enlarged tube can be installed and said plasma mixed with said droplets advances while rotating by said rotational magnetic field, so that the charged droplets and small droplets can be separated by a centrifugal force.

In the present invention, even if the tube axes of said introduction side radially reduced tube and/or the discharge side radially reduced tube are disposed linearly with the tube axis of said radially enlarged tube without bending, it is possible to efficiently recover and remove the droplets diffused in said radially enlarged tube by the radially enlarging action and the radially reducing action of said plasma advancing path by using of said radially enlarged tube. However, according to the eighth form of the present invention, since the tube axes of said introduction side radially reduced tube and/or said discharge side radially reduced tube are inclinedly disposed for a tube axis of said radially enlarged tube, and said introduction side radially reduced tube and/or said discharge side radially reduced tube are connected to said radially enlarged tube, the straightly advancing droplets are separated from the plasma flow by the bending of the plasma advancing path, and they collide with the inner wall surface of the radially enlarged tube and/or the inner wall surface of the discharge side radially reduced tube and can be recovered by bonding. The droplets reflected by the inner wall of said radially enlarged tube without being adsorbed collide with the stepped portion and are recovered, so that it becomes possible to remove the droplets efficiently. The bending portion of said plasma advancing path can be disposed in the introduction side only, the discharge side only, or both of the introduction side and the discharge side. Therefore, it is possible to separate the droplets mixing in the plasma flow with high efficiency, and by ejecting the highly purified plasma flow from said discharge side radially reduced tube, it is possible to improve the droplet removing efficiency. In addition, by decentering the tube axes of the introduction side radially reduced tube and the radially enlarged tube, or by decentering the tube axes of the discharge side radially reduced tube and the radially enlarged tube, it is as mentioned above that the droplet recovering efficiency is improved than the case of coincidence of tube axes.

In parallel arrangement in that the tube axis directions of said introduction side radially reduced tube and the discharge side radially reduced tube are parallel or approximately parallel to each other, since the droplets mixing in the neighborhood of center of the plasma flow passing through said radially enlarged tube are not separated, the droplets pass through said discharge side radially reduced tube, so that the droplets might pass to the plasma treating portion (called plasma processing portion). However, according to the ninth form of the present invention, since said tube axes of said introduction side radially reduced tube and said discharge side radially reduced tube are disposed so as to intersect each other, the plasma flow ejected from said radially enlarged tube collides with the inner wall of said discharge side radially reduced tube intersecting for said introduction side radially reduced tube, and passes through said discharge side radially reduced tube while meandering. Therefore, after the droplets were collected due to adhesion by colliding with said stepped portion neighborhood and the inner side wall of said radially enlarged tube, even if the droplets mixing in the center neighborhood of the plasma flow were ejected from said radially enlarged tube, the droplets advance straightly and collide with the inner wall of said discharge side radially reduced tube, so that they are recovered by adhesion and it is possible to remove the droplets with higher efficiency.

According to the tenth form of the present invention, since said plasma advancing path includes a straightly advancing tube, said introduction side radially reduced tube is connected vertically or almost vertically to said straightly advancing tube, and a droplet collecting portion is disposed at a terminal end of said straightly advancing tube, a part of the droplets generated in said plasma generating portion advance straightly along said straightly advancing tube and they are collected and recovered in said droplet collecting portion. Therefore, since the plasma flow that a part of the droplets were removed flows into said introduction side radially reduced tube connected vertically or almost vertically to said straightly advancing tube by the bending action of the plasma advancing path, the highly efficient removal of the droplets becomes possible based upon the synergistic effect with the droplet removal due to the droplet removing portion in the plasma advancing path of the present invention.

In the case that the droplet removing portion is installed in the plasma advancing path, though the cleaning by exfoliation and recovery of the droplets adhering on the inner wall is necessary, the disassembling of plasma advancing path is accompanied with its cleaning, so that the operation efficacy of the plasma generating apparatus might drop. In there, according to the eleventh form of the present invention, as said inner circumferential tube is freely inserted to and removed from said outer circumferential tube in said radially enlarged tube, said inner circumferential tube polluted by the droplets can be changed at the optional time, the cleaning efficiency of droplets improves and the plasma generating treatment can be done smoothly without decreasing the running efficiency of the plasma generating apparatus. A lot of droplet collecting plates are formed in the inner surface of said inner circumferential tube, and the cleaning and repair of the droplet collecting plates become easy by pulling out the inner circumferential tube. The inner circumferential tube and the outer circumferential tube can be electrically insulated by fixing the inner circumferential tube to the outer circumferential tube through the insulating material such as an insulating ring. Furthermore, since a plurality of droplet collecting plates are arranged, the droplets are repeatedly reflected between droplet collecting plates, so that their energy is lost and it is possible to collect the droplets surely.

According to the sixth form of the present invention, since a plurality of droplet collecting plates are installed on an inner wall of said inner circumferential tube, the droplet adhesion surface area increases in said radially enlarged tube, and a large quantity of droplets can be adhered and recovered surely, so that it is possible to realize the high purification of the plasma flow.

If many droplet collecting plates of said twelfth form are installed in the plasma advancing path, it is possible to increase the droplet removing area, but it is produced a problem that limit occurs in the installed number because of form conditions such as advancing path form and inner diameter. As a result that the present inventor examined zealously concerning said problem, he paid his attention to that the droplets get to adhere easily on rough surface made on the surface of said droplet collecting plate by performing the rough surface processing, and it is possible to improve the collecting efficiency of droplets. That is to say, according to the thirteenth form of the present invention, as a rough surface processing is made on a surface of said droplet collecting plate, the collecting area and adhering strength of said droplet collecting plate increase and the collecting efficiency improves, so that it is possible to contribute to improvement of the droplet removing efficiency.

There is a collecting effect even in the case that the droplet collecting plate is installed so as to be perpendicular to the tube axis for the inner wall of said inner circumferential tube. However, according to the 14th form of the present invention, as said droplet collecting plates are inclinedly disposed for said introduction side radially reduced tube, the droplet collecting probability based on re-reflection increases between the droplet collecting plates, and the escaping droplets become less. Furthermore, since the area receiving the droplets flowing into said radially enlarged tube becomes large, the collecting efficiency of said droplet collecting plate improves and it is possible to contribute to improvement of the droplet removing efficiency still more.

According to the 15th form of the present invention, since an droplet collecting aperture is arranged in said introduction side radially reduced tube and said discharge side radially reduced tube, by way of example only, the tube diameter of the plasma advancing path can be reduced, or the opening shape can be transformed by decentering, so that it is possible to contribute to improvement of the droplet removing efficiency by collecting the droplets straightly advancing at the initial end and the final end of the plasma advancing path.

According to the 16th form of the present invention, since a plurality of said radially enlarged tubes are connected through a radially reduced tube, it is possible to remove the droplets at plural stages and to generate the plasma flow with high purity. In this case, if the tube axes of the radially enlarged tubes are decentered, it is as described above that the droplet collecting efficiency increases.

According to the 17th form of the present invention, said introduction side radially reduced tube, said radially enlarged tube and said discharge side radially reduced tube are electrically insulated with said plasma generating portion and said plasma treating portion (plasma processing portion). In the case that the voltage also is applied to said introduction side radially reduced tube, said radially enlarged tube and said discharge side radially reduced tube, when said introduction side radially reduced tube and said discharge side radially reduced tube are connected to said plasma advancing tube through the insulator, the duct portion of said plasma advancing path is held at the electrically neutral floating state, and at the same time, they are electrically insulated with said plasma generating portion and said plasma treating portion. In the case that the inner circumferential tube is inserted into the radially enlarged tube through the insulating material, said inner circumferential tube is in the electric floating state with other duct portion, and said inner circumferential tube constitutes the duct portion even in this case. Said plasma treating portion is the processing portion treating the object surface to be treated. When the insulating plate is disposed between the initial end side of said duct portion and said plasma generating portion and the insulating plate is disposed between the final end side of said duct portion and said plasma treating portion, the electric insulation is achieved. By this electric insulation, it is possible to float electrically the duct portion (plasma transporting portion). Usually, since the plasma generating portion is set at high electric potential and the plasma treating portion is grounded, by this electric insulation, the duct portion is held at the floating state separated from the high electric potential and GND. As the electromagnetic action for the plasma is eliminated by this electric floating property and the influence to the plasma transporting efficiency is also eliminated, even if the total length of the duct portion becomes long, it is possible to suppress the fall of plasma quantity and plasma density and to prevent the fall of plasma transporting efficiency.

According to the 18th form of the present invention, a quantity of physical property can be measured by inserting a probe into the duct portion for plasma transportation including at least said introduction side radially reduced tube, said radially enlarged tube and said discharge side radially reduced tube. The plasma physical property quantity is the plasma parameter such as ion density, electron density, plasma drift velocity and plasma temperature. When the probe is inserted into the duct portion, there is a case to generate the disturbance in the plasma flow, and the magnitude of probe is adjusted so as to suppress the disturbance as little as possible. The number of the inserted probe is selected variously as one or two. The duct portion in itself can be used as a probe without inserting the probe to avoid this disturbance. The polarity of electric potential applied to said probe or the duct portion used as said probe is selected from positive or negative, and the potential magnitude is variously adjusted, too. In addition, since the plasma has the electric conductivity, the plasma potential is applied to the duct portion in contact with this plasma. Therefore, without completely applying the external voltage, the plasma parameter can be measured from the plasma potential applied to said duct portion by measuring the voltage between the duct portion and GND. There is a case that the values such as wave form and wave height outputted from the probe correspond directly to said plasma parameters, and it is also possible to derive the plasma parameter by calculations. It is needless to say that the technical means applied to the probe measurement can be adjusted according to the plasma conditions.

In the process that the present invention reached completion, in order to achieve an aim of droplet reduction condition, the present inventor found out that the configuration factor becomes the effective element, wherein said configuration factor is one or combination of effective total length, diameter, bending number and summation of bending angle in said plasma advancing path. In there, according to the 19th form of the present invention, since one or combination of effective total length, diameter, bending number and summation of bending angle in said plasma advancing path is set so as to satisfy a droplet reduction condition, it is possible to improve still more the droplet removing effect of the said droplet removing portion disposed in said plasma advancing path.

According to the 20th form of the present invention, since said effective total length being one of said effective element is set at 900 - 1600 mm, it is possible to improve still more the droplet removing effect of the said droplet removing portion disposed in said plasma advancing path.

According to the 21st form of the present invention, since said diameter being one of said effective elements is set at 90 - 200 mm, it is possible to improve still more the droplet removing effect of the said droplet removing portion disposed in said plasma advancing path.

According to the 22nd form of the present invention, since said bending number being one of said effective element is set at 3 - 1, it is possible to improve still more the droplet removing effect of the said droplet removing portion disposed in said plasma advancing path.

According to the 23rd form of the present invention, since said summation of bending angle being one of said effective element is set at 90 - 150 degrees, it is possible to improve still more the droplet removing effect of the said droplet removing portion disposed in said plasma advancing path.

Separately from said configuration factor of said effective element, the present inventor discovered that the arc current value in said plasma generating portion can become the effective element of the droplet removal, too. That is to say, according to the 24th form of the present invention, since an arc current value in said plasma generating portion is adjusted in a range of 30 - 140 A, it is possible to improve still more the droplet removing effect of the said droplet removing portion disposed in said plasma advancing path.

### BRIEF DESCRIPTION OF DRAWINGS

FIG.1 is an outlined schematic diagram of an example of the plasma generating apparatus according to the present invention.
FIG.2 is an outlined schematic diagram of an example of another plasma generating apparatus according to the present invention.
FIG.3 is an outlined schematic diagram of an example of more another plasma generating apparatus according to the present invention.
FIG.4 is a partially enlarged cross section diagram of an inner circumferential tube having a droplet collecting plate.
FIG.5 is an outlined explanation diagram of the droplet collecting plate and its structure.
FIG.6 is a graph diagram showing the relation between the effective total length of the plasma advancing path L (mm), the diameter D (mm), the bending number (NB) and the droplet bonding number on the object to be treated per unit area.
FIG.7 is a graph diagram showing the correlation between the summation of bending angle □ (degree) of the plasma advancing path, arc current value I(A) and droplet removing ratio.
FIG.8 is an outlined configuration diagram of plural radially enlarged tube.
FIG.9 is a conception diagram showing various connection forms of two radially enlarged tubes.
FIG.10 is an outlined schematic diagram of another example of the plasma generating apparatus according to the present invention.
FIG.11 is an explanation diagram showing the state in which the plasma passes through the eccentric passage hole of the aperture disposed in the radially enlarged tube.
FIG.12 is an outlined schematic diagram of the plasma generating apparatus concerning the problems of the present invention.
FIG.13 is an outlined schematic diagram of a conventional plasma processing apparatus.

### DENOTATION OF REFERENCE NUMERALS

- 1: plasma generator
- 2: plasma generating portion
- 3: radially enlarged tube
- 3a: wall surface
- 4: cathode
- 5: plasma advancing path
- 6: trigger electrode
- 7: connection advancing path
- 7a: main bending portion
- 7b: introduction side bending portion
- 7c: discharge side bending portion
- 8: anode
- 9: plasma mixed with droplet (droplet mixing plasma)
- 9a: plasma flow
- 9b: plasma flow
- 10: arc power supply
- 12: plasma processing portion (plasma treating portion)
- 14: object to be treated
- 16: plasma stabilizing magnetic field generator
- 18: droplet
- 20: droplet collecting portion
- 23: radial direction magnetic field generator
- 23a: radial direction magnetic field generator
- 24: straightly advancing magnetic field generator
- 25: aperture
- 25a: eccentric passage hole
- 26: first magnetic field generator
- 27: cathode protector
- 28: bending magnetic field generator
- 30: second magnetic field generator
- 31: third magnetic field generator
- 32: droplet advancing path
- 33: droplet collecting plate
- 34: introduction side radially reduced tube
- 35: outer circumferential tube
- 36: inner circumferential tube
- 37: droplet collecting plate for radially reduced tube
- 38: droplet collecting plate
- 38a: rough surface
- 39: discharge side radially reduced tube
- 40: stepped portion
- 41: straightly advancing tube
- 42: aperture
- 44: processing portion side insulating plate
- 46: insulating material
- 48: bias power supply
- 49: probe power supply
- 50: aperture
- 51: aperture
- 102: plasma generating portion
- 104: cathode
- 106: trigger electrode
- 108: anode
- 109: plasma
- 110: power supply
- 112: plasma processing portion
- 114: object to be treated
- 116a: plasma stabilizing magnetic field generator
- 116b: plasma stabilizing magnetic field generator
- 118: cathode material particle (droplet)
- 120: droplet collecting portion
- 200: radially enlarged tube
- 201: radially enlarged tube
- 202: intermediate radially reduced tube
- 203: introduction side radially reduced tube
- 204: discharge side radially reduced tube
- 300: object to be plasma-treated
- 301: plasma processing portion
- 302: plasma flowing path
- 303: rib
- 304: cathode
- 306: trigger electrode
- 307: arc power supply
- 308: plasma
- 309: housing
- 401: plasma processing portion
- 402: plasma advancing path
- 402a: initial end portion of advancing path
- 403: insulator
- 404: plasma
- 405: anode
- 406: droplet removing device
- 407: cathode
- 408: trigger electrode
- 409: arc power supply
- 411: collecting member
- 412: plasma advancing path
- 413: droplet collecting portion
- 414: plasma
- 415: droplet
- 416: droplet removing device
- 417: aperture
- 418: droplet collecting plate
- 420: enclosure member
- 500: enclosure member
- 501: collecting member
- A1 - A7: collecting member
- B1 - B9: collecting member

### BEST MODE FOR CARRYING OUT THE INVENTION

As follows, the preferred embodiments of the plasma generating apparatus according to the present invention are explained in detail based on the accompanied drawings. In the present invention, the plasma generating apparatus includes the apparatus which installs the plasma processing portion to process the object to be treated and the apparatus which does not install the plasma processing portion. The plasma generating apparatus having the plasma processing portion is referred to as the plasma processing apparatus.

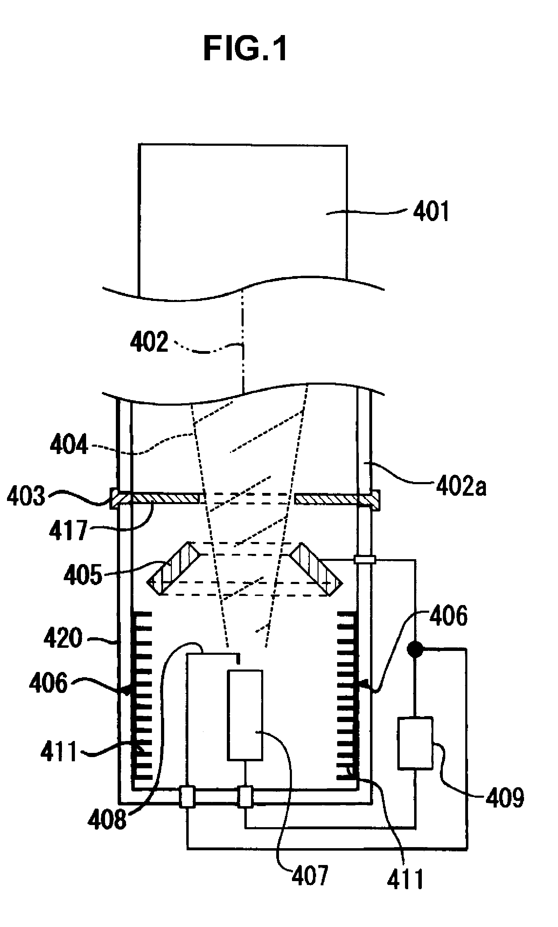

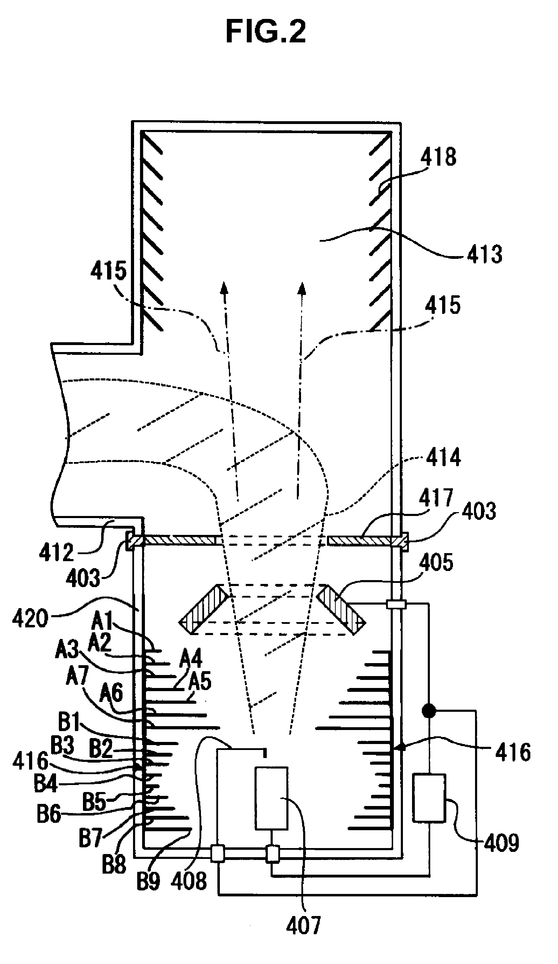

FIG.1 is an outlined schematic diagram of the plasma generating apparatus according to the present invention. The plasma generating apparatus shown in FIG.1 is composed of a plasma generating portion generating the plasma by vacuum arc discharge under vacuum atmosphere (plasma gun), the plasma processing portion 402 and the plasma advancing path 402. In the present specification, the plasma advancing path 402 shows the path from the plasma generating portion inducing the plasma (plasma gun) to the plasma processing portion 401, and as described later, the plasma advancing path is constituted from the duct portion provided with one or more magnetic generators inducing the plasma by electromagnetic interaction, which is given a function as a filter tube removing the droplets. For example, though the plasma advancing path 402 may be formed so as that the plasma advances straightly, it is preferable that one or more bending portions inducing only the plasma are disposed. Furthermore, as described later, to the bending portion of the plasma advancing path 402, it is connected the pocket-like collecting portion that can catch the droplets advancing straightly. In the plasma advancing path of FIG.2, the structure to remove the droplets is not described concretely, but it is possible to select freely the structure of the plasma advancing path and the attachment device as stated later.

The plasma generating portion is constructed from cathode 407, trigger electrode 408, anode 405 and arc power supply 409. The cathode 407 is a supply source of plasma constituent material, and the formation material is a solid having conductivity not particularly limited, so that metal simple substance, alloy, inorganic simple substance and inorganic compound (metallic oxide / nitride) etc. can be used as single substance or mixture of two substances or more. The formation material of the anode 8 is not particularly limited as far as it is a solid that does not evaporate even at the plasma temperature and are both of nonmagnetic material and conductive material. Said anode 405 has the annular structure reducing radially along the plasma advancing direction and the function as aperture, too. However, the shape of the anode 405 is not particularly limited as far as it does not largely shield the progression of whole plasma.

The periphery of cathode 407 is surrounded with the enclosure member 420. The enclosure member 420 is connected to the initial end 402a of the plasma advancing path 402 through the insulator 403. The final end opening of the plasma advancing path 402 is connected to the plasma introduction opening of the plasma processing portion to introduce the plasma 404 generated from said plasma gun. In the inside of the plasma processing portion 401, the object to be plasma-treated (not shown) is disposed at the plasma irradiation position, so that it is possible to perform the plasma treatment according to the object. On the inside of the enclosure member 420, there is provided the droplet removing device 406 constituted by laying a plurality of collecting members 411 in multilayer, which catch the droplets by-produced from the cathode 407 at the plasma generating time. Moreover, at the final end portion of the enclosure member 420, the initial end portion 402a of the advancing path, their connection portion, or its vicinity, there is disposed the aperture for collecting the droplets by which it can be suppressed that the droplets penetrate to the plasma advancing path 402. Further, the aperture 417 may be formed in one body with said insulator 403, so that it is possible to dispose the aperture more easily. Said enclosure member 420 and said plasma advancing path 402 (including the initial end portion 402a of advancing path) are held at the electrically neutral floating state without the connecting relation to the arc power supply 409. In addition, said plasma advancing path 402 and said enclosure member 420 are formed from metallic material such as SUS, and when the cathode 407 is formed from carbon substance, the collecting member 411 is formed from carbon substance such as carbon graphite being the same substance as the cathode 407.

In the plasma generating apparatus constituted above, the electrically neutral droplets are scattered to the periphery of the cathode 407, and collide with each collecting member 411 disposed on the enclosure member 420, so that they adhere and are collected. In this collection of droplets, the enclosure member 420 is held at the electrically neutral floating state, so that electrons in the generated plasma 404 are not attracted to the enclosure member 420 side, and move to the initial end portion 402a of advancing path of the anode 405 side apart from the cathode 407. Therefore, in the case of droplet collection by the droplet removing device 406, the electrical discharge phenomenon does not occur, and the energy loss does not occur. By this, since the collecting member 411 is disposed in proximity to said plasma gun, it is possible to perform the droplet removal with high efficiency and to supply the plasma with high purity and high energy to the plasma advancing path 402.

Each collecting member 411 is formed with an annular plate like hollow ring of which hollow portion for flowing the plasma is drilled and is made of carbon graphite or SUS, etc. Said droplet removing device 406 is provided with the structure integrated in multilayer by disposing a plurality of collecting members 411 of the same shape with a predetermined interval and is detachably installed on the inner circumference of the enclosure member 420. When the collecting member 411 is polluted with adhesion of droplets, it is possible to clean each collecting member 411 by pulling out the droplet removing device from the enclosure member 420.

Since each collecting member 411 is disposed in multilayer on the inside of the enclosure member 420 so as to enclose the cathode 407 along the advancing direction of the generated plasma, the collectable area of droplet becomes large, so that it is possible to improve the droplet removing efficiency. Since the droplets not only advance straightly in the plasma advancing direction but also scatter to the periphery of the cathode 407 because of rebounding backwards by collision with the inner wall of the enclosure member 420, the collecting members 411 also are disposed at the rear and the side of the cathode 407, so that it is possible to collect the droplets scattered backward and sideward around the cathode 407 and it is prevented that the droplets rebounded forward are mixed with the plasma flow. Additionally, if the collecting members for removing the droplets are disposed on the inner wall of the plasma advancing path 402, it is possible to improve the droplet removing efficiency even more.

FIG.2 is an outlined schematic diagram of another plasma generating apparatus concerning the present invention. In FIG.2, the explanation of the same member as one of FIG.1 is omitted by giving the same symbol. This plasma generating apparatus is provided with the plasma advancing path 412 formed in a bent shape approximately perpendicular to the plasma generating portion (plasma gun), and the droplet removing device 416 is installed detachably on the inner circumference of the enclosure member 420. In the same manner as the plasma generating apparatus in FIG.2, the enclosure member 420 is connected to the initial end of the plasma advancing path 412 through the insulator 403, and the enclosure member 420 and the plasma advancing path 412 are held at the electrically neutral floating state.

Said droplet removing device 416 is provided with the structure integrated a plurality of collecting members A1 to A7 and B1 to B7 with a predetermined interval in multilayer, and is detachably installed on the inner circumference of the enclosure member 420. Each collecting member 411 is formed with an annular plate like hollow ring of which hollow portion for flowing the plasma is drilled and is made from carbon material such as carbon graphite or metallic material such as Ti, W and SUS, but it is preferable that it is made from the same material as the cathode 407, as described above. In each collecting member, the inner diameter of each hollow portion differs. The collecting members A1 to A7 located ahead of the cathode 407 are arranged in multilayer so as that the size of each hollow portion slightly enlarges along the advancing direction of the plasma 414. In addition, the collecting members B1 to B9 are disposed even at the rear and the side so as to surround the cathode 40, and they catch the droplets scattered even to the rear and the side of the cathode 407, so that it is prevented that the droplets rebounded forward are mixed with the plasma flow. Still, each of said collecting member may be held at the electrically neutral floating state and the collecting member made from non-conducting material such as ceramic may be used.

In said droplet removing device 416, since the collecting members A1 to A7 are arranged in multilayer on the inner wall of the enclosure member 420 with a predetermined interval in order of size of each hollow portion toward the plasma advancing space ahead of the cathode 407, it is possible to improve the droplet removing efficiency by enlarging of the collectable area of droplets. In addition, the hollow portions of the collecting members A1 to A7 form the plasma advancing space that is disposed in a reverse truncated cone geometry from said cathode to the front. Accordingly, while removing the droplets with high efficiency, it is possible to decrease the rate that the generated plasma 414 emitted in the shape of about cone from said cathode to the front collides with said collecting member, and it is possible to advance the high purified plasma smoothly through said plasma advancing space, so that the efficient utilization of the generated plasma can be performed. In this collection of droplet, same as the plasma generating device in FIG.1, since the enclosure member 420, the collecting member 416 and the plasma advancing path 412 are held at the electrically neutral floating state, the electrical discharge phenomenon does not occur and the energy loss is not generated.

Furthermore, since the droplets 415 generated in the plasma generating portion are electrically neutral and they are collected by the droplet collecting portion 413 faced to the plasma generating portion because of straight advancement due to inertia force, it is possible to introduce the plasma 414 from which the droplets 415 advancing straightly are collected in the droplet collecting portion 413 to the plasma advancing path 412. In addition, a plurality of droplet collecting plates 418 are arranged at a slant to the straightly advancing droplet on the inner wall of the droplet collecting portion 413, so that it can be prevented that the droplet 415 reflecting on the wall surface is mixed with the plasma 414 again. Therefore, according to the plasma generating apparatus, the droplets scattered at the periphery of the cathode 407 are removed by the droplet removing device 416, and the straightly advancing droplets 415 are caught by the droplet collecting portion 413, so that it is possible to send the plasma with higher purity to the plasma advancing path 412 side by the synergistic effect of droplet removal. Still, the high purity plasma is guided in a bent condition to the plasma processing portion side by the magnetic action based upon the bending magnetic field generator (not illustrated) arranged at the plasma advancing path 412.

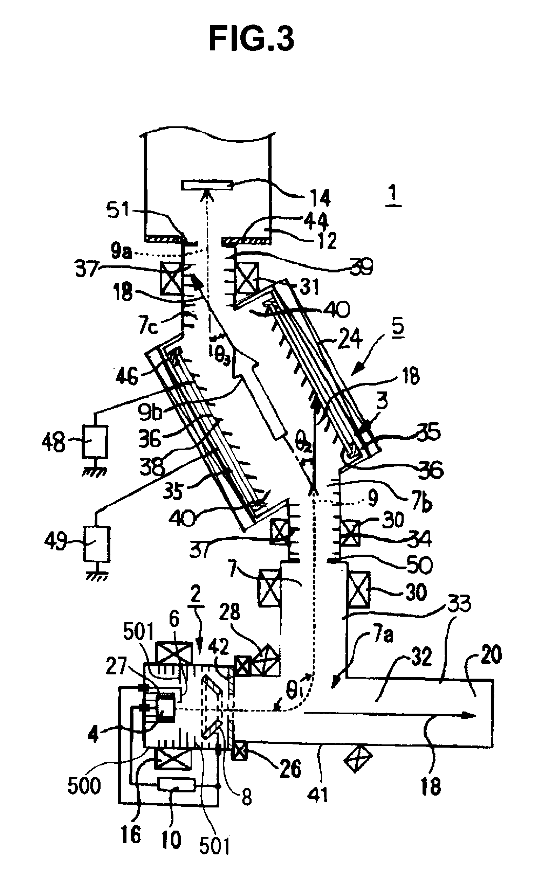

FIG.3 is an outlined schematic diagram of more another plasma generating apparatus according to the present invention. The plasma generating apparatus 1 shown in FIG.3 is comprised of the plasma generating portion 2, the plasma processing portion 12 and the plasma advancing path 5. In the plasma advancing path 5, there is disposed the droplet removing portion which removes the droplets by-produced from the cathode 4 at the plasma generating time. Said plasma removing portion is composed of the radially enlarged tube 3 forming the plasma advancing path 5, the introduction side radially reduced tube 34 connected to the plasma introducing side initial end of said radially enlarged tube 3, the discharge side radially reduced tube 39 connected to the plasma discharge side terminal end of said radially enlarged tube 3, and the stepped portions 40 formed at the initial end and the terminal end of said radially enlarged tube 3. The connection advancing path 7 is connected to the preceding stage of the introduction side radially reduced tube 34.

The straightly advancing tube 41 is arranged ahead of the plasma generating portion 2, and said connection advancing path 7 is arranged through the main bending portion 7a with the bending angle □1 of 90 degrees from said straightly advancing tube 41. The droplet advancing path 32 is formed in said straightly advancing tube 41 ahead from the main bending portion 7a of this connection advancing path 7. The radially enlarged tube 3 and the introduction side radially reduced tube 34 are connected so as to intersect each other through the introduction side bending portion 7b, and the bending angle □2 of said introduction side bending portion 7b is 30 degrees in this embodiment. In addition, the bending angle □3 between the discharge side radially reduced tube 39 and the radially enlarged tube 3 is also set at 30 degrees, so that the summation of bending angle □ (= □1 + □2 + □3) becomes equal to 150 degrees. The radially enlarged tube 3 is composed of the inner circumferential tube 36 and the outer circumferential tube 35. The outer circumferential tube 35 does not participate in progression of the plasma, and it is the protection member of the inner circumferential tube 36, which is installed in the outer circumferential tube 35 through the insulating material such as insulating ring, so that the inner circumferential tube 36 and the outer circumferential tube 35 are electrically insulated with regard to each other. The inner circumferential tube 36 integrated with the insulating material 46 is constituted so as to be separated and taken out from the outer circumferential tube 35.

The plasma generating portion 2 comprises the cathode 4, the trigger electrode 6, the anode 8, the arc power supply 10, the cathode protector 27, and the plasma stabilizing magnetic field generator (electromagnetic coil or magnet) 16, and the anode 8 is connected to the positive potential of the arc power source 10. The cathode protector 27 electrically insulates except the evaporating cathode surface, and it is prevented that the plasma generated between the cathode 4 and the anode 8 diffuses backwardly. The plasma stabilizing magnetic field generator 16 is disposed on the outer circumference of the plasma generating portion 2 and stabilizes the plasma. When the arc stabilizing magnetic field generator 16 is disposed so as to make the applied magnetic field to the plasma in the reverse direction (cusp form) to each other, the plasma is stabilized even more. In addition, the aperture 42 is disposed in the connection portion between the plasma generating portion 2 and the straightly advancing tube 41. Furthermore, the front portion from the straightly advancing tube 41 is electrically in the floating state, and it is constituted so as that the plasma is not electrically influenced in the plasma advancing path. Additionally, the processing portion side insulating plate 44 is also disposed between the discharge side radially reduced tube 39 and the plasma processing portion 12. As a result, the whole duct portion for transporting the plasma from the straightly advancing tube 41 to the discharge side radially reduced tube 39 is set in the electric floating state, the energy loss of plasma is suppressed.

The power supply 48 is connected to the inner circumferential tube 36, and it is possible to set the inner circumferential tube 36 at positive potential or negative potential, so that it is possible to probe said plasma parameter. The direction not to reduce the plasma transportation efficiency is selected in relation to which of positive and negative is chosen, and this is judged from the condition of plasma. The magnitude of potential can be also changed, and it is selected from the point of view of the plasma transporting efficiency to set usually the inner circumferential tube at +15V. The probe power supply 49 is connected to the outer circumferential tube 35, and the electric potential of said duct portion connected to the outer circumferential tube 35 is adjusted. Because the plasma in itself has the plasma potential, the potential of the duct portion becomes the synthesized potential in which the probe potential and the plasma potential are superimposed. When the synchroscope is connected between the duct portion and GND, the wave form of said synthesized potential is measured, and the plasma parameters can be measured from this peak value and period, etc. In the case that the probe power supply is not connected, the potential of the duct portion becomes equal to the plasma potential, and it is possible to measure the plasma potential by connecting the synchroscope between the duct portion and GND. Since the plasma in itself has the electric conductivity, said content can be understood because of that the potential of the duct portion reflects the plasma potential.

In the plasma generating portion 2, the electric spark occurs between the cathode 4 and the trigger electrode 6, so that the vacuum arc occurs between the cathode 4 and the anode 8, and the plasma is generated. The constituent particle of this plasma includes the vaporized material from the cathode 4, the charged particle (ion, electron) originated from said vaporized material and the reaction gas, and the neutral particle of molecule and atom of plasma precursor state. Additionally, at the same time as the plasma constituent particle is emitted, the droplet 18 having the size of less than sub-micron to several hundred micron (0.01 - 1000 µm) is emitted. This droplet 18 forms the mixed state with the plasma flow, and advances through the plasma advancing path 7 as the droplet mixing plasma 9.

In the droplet removing portion disposed in the plasma advancing path 5, the plasma flow guided from the introduction side radially reduced tube 34 to the radially enlarged tube 3 is diffused by the radially enlarging action of the plasma advancing path due to the radially enlarged tube. Although the plasma flow 9b spreads, because the droplet mixing in the plasma advances straightly, the droplets diffuse inside of the radially enlarged tube 3 while colliding with the inner wall surface of the radially enlarged tube 3. By this diffusion, the droplets decrease in the center portion of the droplet flow, and the plasma flow changes to the state that many droplets distribute at the outer circumference of the plasma flow. By this distribution change, the droplets collide with the neighborhood of the stepped portion 40 and the inner wall surface of the inner circumferential tube 36, and they are adhered and recovered. In addition, when the plasma flow in the inner circumferential tube 36 is discharged, by the radially reducing action from the inner circumferential tube 36 to the discharge side radially reduced tube 39, the droplets scattered to the inner side wall of the inner circumferential tube 36 can be prevented to join to the plasma flow 9b and to mix again. The droplets 18 jumping out from the discharge side bending portion 7c advance straightly and are recovered by colliding with the inner wall surface of the discharge side radially reduced tube 39, but the plasma flow curves along the discharge side bending portion 7c by the magnetic field and the plasma flow is separated from the droplets 18. As a result, since almost all droplets 18 are separated from the plasma flow 9b and collected, the pure plasma 9a is supplied to the plasma processing portion 12. Therefore, the droplets are adhered on the neighborhood of the stepped portion 40 and the inner wall surface of the inner circumferential tube 36 and can be recovered fully, so that it is possible to remove efficiently the droplets in the plasma advancing path 5. Besides, it is possible to constitute easily and cheaply the droplet removing portion by only forming the radially enlarged tube 3 in the plasma advancing path, and when the high purity plasma obtained by improvement of the droplet removing efficiency is guided to the plasma processing portion 12, it is possible to improve the processing precision of surface treatment of filming and to improve still more the surface modification of the object surface to be treated and the uniformity of the formed film. The inner diameters of the introduction side radially reduced tube 34 and the discharge side radially reduced tube 39 are the same, and the radially enlarged degree of the inner circumferential tube 36 of the radially enlarged tube 3 to the former may be around 1.2 to 3.

The periphery of cathode 4 is surrounded with the enclosure member 500. The enclosure member 500 is connected to the initial end of the straightly advancing tube 41 through the insulator (not shown), and does not electrically conduct to the straightly advancing tube 41. On the inside of the enclosure member 500, there are disposed in multilayer a plurality of collecting members 501 which catch the droplets by-produced from the cathode 4 at the plasma generating time. The collecting member 501 has the same constitution as the collecting member 411 in FIG.1. As explained with respect to the plasma generating apparatus of FIG.1, the electrically neutral droplets are scattered to the periphery of the cathode 4 by the inertial force, and collide with each collecting member 501 disposed on the enclosure member 500, so that they adhere and are collected. In this collection of droplets, the enclosure member 500 does not conduct to the straightly advancing tube 41, and is held at the electrically neutral floating state. That is to say, the enclosure member 500 is insulated from the anode 8 and the straightly advancing tube 41, so that electrons in the plasma are not attracted to the enclosure member 500, and move to the straightly advancing tube 41 through the annular anode 8 apart from the cathode 4. Accordingly, the electrical discharge phenomenon does not occur between the cathode 4 and the collecting member 501 conducting to the enclosure member 500, so that the energy loss is suppressed. By this, since the collecting member 501 can be arranged in proximity to the cathode 4, it is possible to perform the droplet removal with high efficiency and to generate the plasma with high purity and high energy.

As the inner circumferential tube is freely inserted to and removed from the outer circumferential tube in said radially enlarged tube, the inner circumferential tube 36 polluted by the droplets can be changed at any time, and the cleaning performance of the droplet is improved and it is possible to perform smoothly the plasma generating treatment without decreasing the running efficiency of the plasma generating apparatus.

As for the introduction side radially reduced tube 34 and the discharge side radially reduced tube 39, their tube axes are inclinedly disposed with the predetermined bending angle (□2 + □3 = 60 degrees) to the tube axis of the radially enlarged tube 3, and their conjugation surfaces to the radially enlarged tube 3 become the shape of elliptic. By this, since the bending type plasma advancing path is formed by the introduction side radially reduced tube 34, the discharge side radially reduced tube 39 and the radially enlarged tube 3, the droplets diffused in the radially enlarged tube 3 can be adhered and recovered by colliding with the neighborhood of the stepped portion 40 and the inner side wall of the radially enlarged tube 3. Therefore, the droplets mixed in the plasma flow can be separated with high efficiency, and because the highly purified plasma flow is discharged (ejected) from said discharge side radially reduced tube, it is possible to improve the droplet removing efficiency.

In the present embodiment, the tube axes of the introduction side radially reduced tube 34 and the discharge side radially reduced tube 39 are connected to the initial end and the final end of the radially enlarged tube 3 in the same direction, respectively, and it is the case of parallel arrangement (□2 = 30 degrees, □3 = 30 degrees). In addition, for example, when the tube axis of the discharge side radially reduced tube 39 is inclined to the tube axis of the radially enlarged tube 3 in the reverse direction with 30 degrees (□3 = -30 degrees), the tube axes of the introduction side radially reduced tube 34 and the discharge side radially reduced tube 39 are intersected each other to the initial end and the final end of the radially enlarged tube 3 in the same direction, and it is the case of intersection arrangement (□2 = 30 degrees, □3 = -30 degrees). Hence, the plasma flow discharged from the radially enlarged tube 3 collides with the inner wall of the discharge side radially reduced tube 39 intersecting to the introduction side radially reduced tube 34, so that it is possible to pass the plasma flow through the discharge side radially reduced tube while meandering. Therefore, in comparison with the case of said parallel arrangement, after the droplets were adhered and recovered by colliding with the neighborhood of the stepped portion 40 and the inner side wall of the inner circumferential tube 36, even if the droplets mixing in the center neighborhood of the plasma flow are discharged from the inner circumferential tube 36, the droplets advance straightly and are adhered and recovered by colliding with the inner wall of the discharge side radially reduced tube 39, and it is possible to remove the droplets with high efficiency.

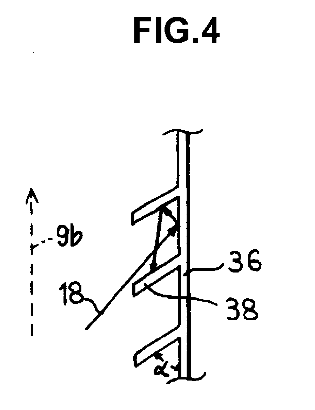

FIG.4 is a partially enlarged cross section diagram of the inner circumferential tube 36 having the droplet collecting plate 38. A plurality of droplet collecting plates 38 is installed on the inner wall of the inner circumferential tube 36. The slant angle □ of the droplet collecting plate 38 is set in the range of 15 to 90 degrees, the range of 30 to 60 degrees is empirically preferable and the angle is set □ = 45 degrees in this example. In this slant angle, the droplets 18 separated from the plasma flow 9b can be surely adhered and recovered while multiple-reflecting the droplet collecting plate 38 as shown in the diagram.

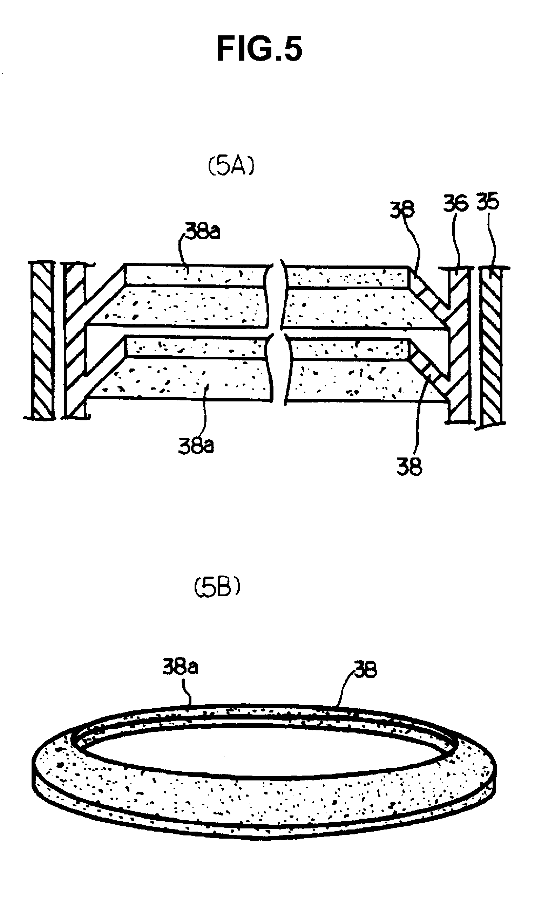

FIG.5 is a partial cross section diagram of the structure of the droplet collecting plate 38, (5A) is its partial cross section and (5B) is an appearance diagram of one sheet of droplet collecting plate 38. The droplet adhering surface area in the inner circumferential tube 36 becomes large by a plurality of droplet collecting plates 38, and it is possible to adhere and recover the scattered droplets surely and in large quantities. Because, in the plasma advancing path, the set number of sheets of droplet collecting plates 38 is limited by restriction due to the tube length of the inner circumferential tube 36, the rough surface treatment is done on the surface of the droplet collecting plate 38 to increase the droplet removing area, so that the rough surface 38a having the innumerable unevenness are formed. Because the surface of the droplet collecting plate 38 becomes the rough surface 38a, the collecting area of the droplet collecting plate 38 increases and the collecting efficiency can be improved.
In addition, the droplet 18 colliding with the recess is surely bonded in the recess and the droplet collecting efficiency increases markedly. The lineage elaboration and the pear tree place elaboration can be used for said rough surface processing 38a. For example, as for the lineage elaboration method, the polish treatment with abrasive paper is used.
For example, as for the pear tree place elaboration method, the blasting by alumina, shot, grid, or glass bead is used, and especially, by using the micro-abrasive blasting elaboration that the grains with several micron size are jetted through nozzle with compressed air for acceleration, it is possible to perform the convexoconcave elaboration for narrow surface of the droplet collecting plate 38.

As explained above, since the droplet collecting plate is important, it will be written down again here. The collecting surface of the droplet collecting plate 38, as shown in FIG.5, inclines to the inner wall of the inner circumferential tube 36 by about 45 degrees. Therefore, in the state that the droplet collecting plate 38 is installed in the inner circumferential tube 36, the collecting surface is inclinedly disposed toward the introduction side radially reduced tube 34, so that the area receiving the droplets flowing into the inner circumferential tube 36 increases. Therefore, by improvement of the collecting efficiency of the droplet collecting plate 38, it is possible to raise the droplet removing efficiency still more. In addition, by inclination of about 45 degrees, the collected droplets collide and reflect with the collecting surface, so that it is possible to prevent the jumping out from the collecting plate again. The similar droplets collecting plates 37 for the radially reduced tube are installed in the introduction side radially reduced tube 34 and the discharge side radially reduced tube 39, too. Although this droplet collecting plates 37 for the radially reduced tube are disposed uprightly to the inner surface of the radially reduced tube, it is needless to say that it is disposed inclinedly with appropriate slant angle at the same manner as said droplet collecting plate 18. Besides, many droplet collecting plates 33 are disposed on the inner surface of the tube wall of the connection advancing path 7 and the droplet advancing path 32, but the drawing is omitted. The inclination arrangement of these droplet collecting plates 33 is set in the same manner as described above.

In FIG. 3, in the straightly advancing tube 32 to which the connection advancing path 7 is connected, the first magnetic field generator 26 and the bending magnetic field generator 28 are disposed, and the second magnetic field generator 30, 30 are disposed on the outer circumference of the connection advancing path 7 and the introduction side radially reduced tube 34. The straightly advancing magnetic field generator 24 is arranged on the outer circumference of the radially enlarged tube 3, and the third magnetic field generator 31 is arranged on the outer circumference of the discharge side radially reduced tube 39. The first magnetic field generator 26, the second magnetic field generator 30, the third magnetic field generator 31 and the straightly advancing magnetic field generator 24 are installed to advance the plasma forwardly. The bending magnetic field is applied by the bending magnetic field generator 28 inclinedly arranged at the bending portion 7a, so that the droplet mixing plasma 9 (plasma mixed with droplets) emitted from the plasma generating portion 2 is bent at the bending portion 7a. Then, the electrically neutral droplets 18 do not receive the influence of the bending magnetic field, so that the droplets advance through the droplet advancing path 32 by the inertial force, and they are collected by the droplet collecting portion 20 arranged at the final end of the droplet advancing path 32. Therefore, in the introduction side radially reduced tube 34 connected vertically or almost vertically to the droplet advancing path 32 through the connection advancing path 7, the plasma flow of which a part of droplets were removed beforehand flows into by the bending action of the plasma advancing path, so that the highly efficient removal of the droplets becomes possible by synergistic effect with the droplet removal due to the droplet removing portion disposed in said plasma advancing path 5. Moreover, by disposing the introduction side radially reduced tube 34 and the discharge side radially reduced tube 39 inclinedly to the radially enlarged tube 3, it is possible to increase the droplet collecting efficiency still more.

The introduction side radially reduced tube 34 is only a little radially reduced in comparison with the connection advancing path 7, and the droplet removal is done by this radially reducing action, but the droplet collecting aperture 50 is arranged in the vicinity of the connection portion with the connection advancing path 7. The droplet collecting aperture 51 is arranged near the opening of the plasma processing portion 12 side of the discharge side radially reduced tube 39. As for the apertures 50, 51, there is used the circular plate type aperture of which the opening shape is deformed so as to contract or decenter the tube diameter of the plasma advancing path and deformed so as to contract and decenter said tube diameter. By arranging these apertures 50, 51, the straightly advancing droplets are collected at the initial end and the final end of the plasma advancing path, so that it is possible to contribute the improvement of the droplet removing efficiency.

In the plasma generating apparatus 1 concerning said constitution, by the collecting member 501 disposed on the enclosure member 500, the droplet collecting portion 20, the droplet removing portion of the plasma advancing path 5 and apertures 50, 51, the droplets are removed to form the high purity plasma 9a, which advances by being guided due to the magnetic field of the third magnetic field generator 31 arranged at the discharge side radially reduced tube 39, and the object surface to be treated 14 is treated by guiding to the plasma processing portion 12. Therefore, it is possible to perform the uniform surface modification on the object surface to be treated with the high purity plasma and to form the thin film of high quality with little defect and little impurity.

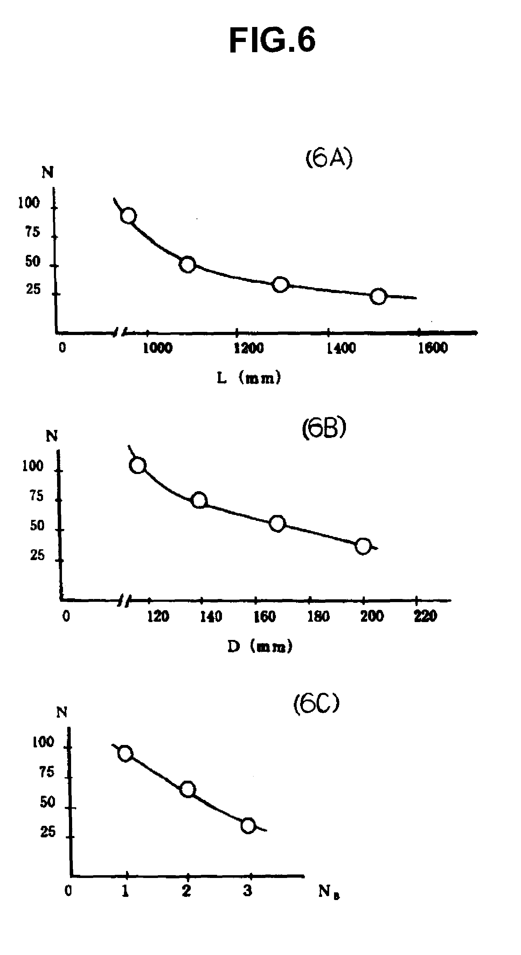

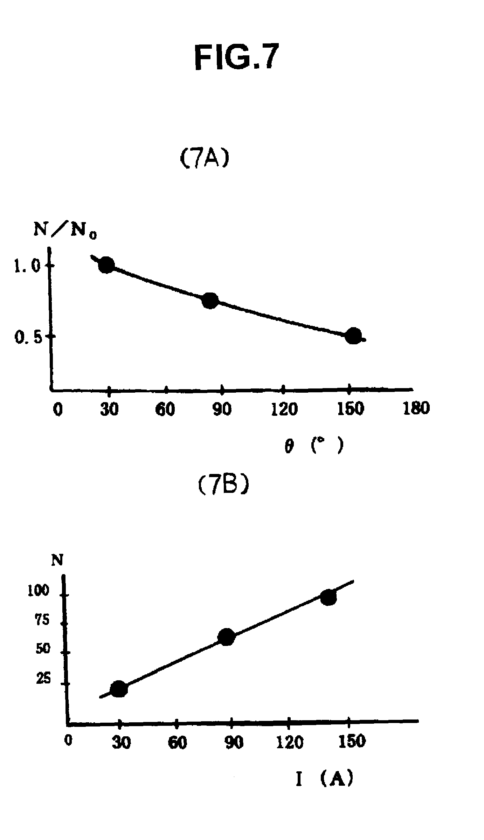

According to the findings that the present inventor got, in order to achieve an aim of droplet reduction condition, the configuration factor becomes the effective element, wherein said configuration factor is one or combination of effective total length, diameter, bending number and summation of bending angle in the plasma advancing path. FIG. 6 and FIG. 7 (7A) show the consequence that the availability on these configuration factors is inspected. In this verification, the plasma advancing path was formed by the duct of the same diameter over full length.

FIG.6 is a graph diagram showing the relation among the effective total length of the plasma advancing path L (mm), the diameter D (mm), the bending number NB and the droplet removing ratio. FIG.7 (7A) is a graph diagram showing the correlation among the summation (= □1 + □2 + □3) of bending angle of the plasma advancing path and the droplet removing ratio. Longitudinal axis N in FIG. 6 shows the droplet bonding number on the object to be treated per unit area (2.5 inch □2.5 inch). When, for example, the 10nm film is formed with the deposition rate of 10A/sec (A = 0.1 nm), N < 100 was set as the desired value of the surface treatment ability in the plasma processing portion 12, namely as the desired value of the droplet reduction condition.

As found from FIG.6, said droplet reduction condition can be satisfied by setting the effective total length at 900 - 1600 mm, by setting the tube diameter at 90 - 200 mm, and by setting the bending number at 3 to1.

The N/N0 of the longitudinal axis in FIG.7 (7A) shows the comparison with the droplet bonding number N0 on the object to be treated in only the straightly plasma advancing path. The smaller the value of N/N0 is under the condition of N/N0 < 1, the higher the surface treatment ability in the plasma processing portion 12 becomes, so that it is set as the desired value of the droplet reduction condition. The bending angle is the angle at which the duct is bent for the advancing direction of the plasma flow. As found from (7A), since the summation of the bending angle is set at 90 - 150 degrees, said droplet reduction condition can be satisfied.

From said verification results, when one or combination of effective total length, diameter, bending number and summation of bending angle in said plasma advancing path is set so as to satisfy the droplet reduction condition, it is possible to improve still more the droplet removing effect of the said droplet removing portion disposed in said plasma advancing path.
In said embodiment, the effective total length, the diameter, the bending number and the summation of bending angle in said plasma advancing path are set at 1500 mm, 200 mm, 3 (three positions of main bending portion 7a, introduction side bending portion 7b and discharge side bending portion 7c) and 150 degrees (90 + 30 + 30), respectively, and the effective element of said configuration factor is included.

Furthermore, separately from said configuration factor of said effective element, the arc current value in said plasma generating portion 2 also affects the droplet bonding number on the object to be treated per unit area (2.5 inch □2.5 inch). FIG. 7 (7B) shows the relation between the droplet bonding number on the object to be treated and the arc current value in the plasma generating portion 2. As described above, N < 100 becomes the target value of said surface treatment ability. As shown in (7B), when the arc current value reaches 150 A, the droplet bonding number exceeds 100. On the basis of this test result and the findings of the present inventors, when the arc current value in the plasma generating portion is adjusted in the range of 30 - 140 A, the target value of said surface treatment ability is satisfied and it becomes clear that the plasma larger than a predetermined quantity enabling the plasma treatment is generated.

When a plurality of radially enlarged tubes are connected through the radially reduced tube, it is possible to improve the droplet removing efficiency.

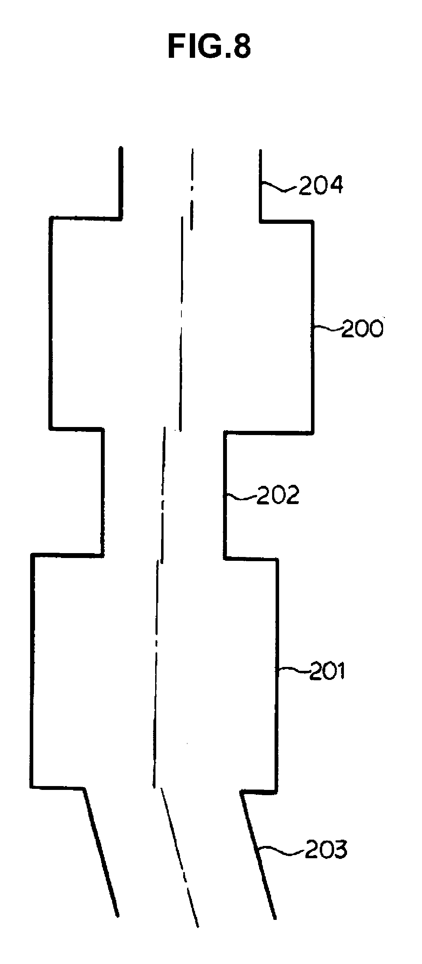

FIG.8 is one example of plural radially enlarged tube arrangement, and shows the plasma advancing path connecting linearly two radially enlarged tubes 200, 201 through the intermediate radially reduced tube 202. The introduction side radially reduced tube 203 is inclinedly arranged to the radially enlarged tube 201, the radially enlarged tube 201 is connected to the radially enlarged tube 202 through the intermediate radially reduced tube 202, and the discharge side radially reduced tube 204 is connected to the radially enlarged tube 200. By these connected radially enlarged tubes 200, 201, the droplets can be removed over plural stages and the high purity plasma flow can be generated. Besides, as shown in the diagram, by decentering so as not to coincide the tube axes of the connected duct, it is possible to raise the droplet removing effect at the stepped portion formed in the radially enlarged tubes 200, 201. In addition, when the intermediate radially reduced tube 202 is curvedly formed and the plasma inducing magnetic field generator is arranged outside, a plurality of radially enlarged tubes may be connected while increasing the bending degree of the plasma advancing path.

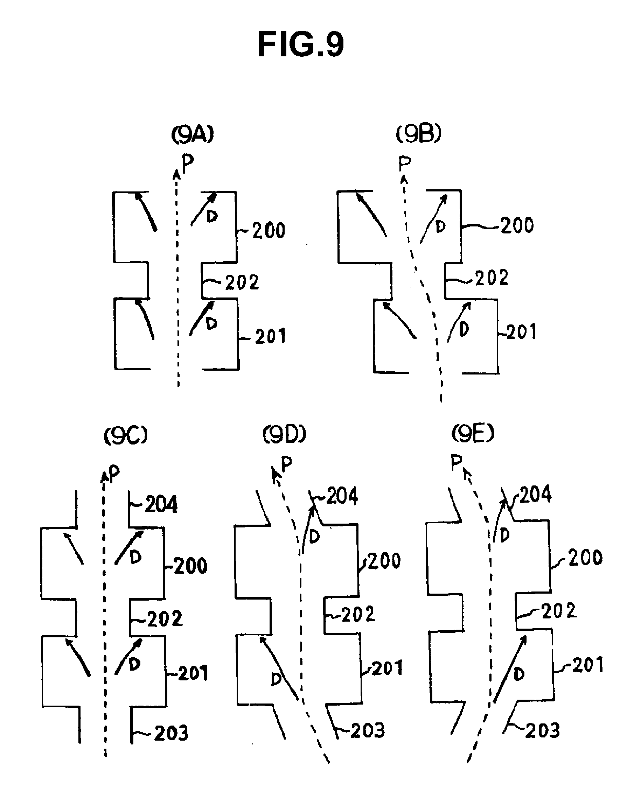

FIG.9 is the conception diagram showing various connection forms of two radially enlarged tubes. In FIG.(9A), the case coinciding the tube axes of the radially enlarged tubes 200, 201 is shown. In this case, the plasma flow P advances linearly, so that the droplets D are collected with the stepped portion and the inner circumferential surface of the radially enlarged tube. In FIG. (9B), the case shifting the tube axes of the radially enlarged tubes 200, 201 is shown. In this case, the plasma flow P meanders a little and since the droplets D are separated from the plasma flow P by this meandering, the collection of the droplets D at the stepped portion is strengthened. FIG. (9C) is the case that the introduction side radially reduced tube 203 and the discharge side radially reduced tube 204 are parallel arranged (□2 = 0, □3 = 0). The slant angles □2, □3 are defined in the same manner as in FIG. 1. In this case, the plasma flow P advances straightly and the droplets D are collected at the stepped portion of the radially enlarged tube. FIG (9D) corresponds to the case that the introduction side radially reduced tube 203 and the discharge side radially reduced tube 204 are inclinedly arranged (□2 = -30 degrees, □3 = -30 degrees). As a result, the introduction side radially reduced tube 203 is parallel with the discharge side radially reduced tube 204. In this case, the plasma flow P meanders in sigmoid, and since the droplets D are separated from the plasma flow P by this sigmoid meandering, the collection effect of the droplets D at the stepped portion of the radially enlarged tube is strengthened. FIG. (9E) shows the case that the introduction side radially reduced tube 203 and the discharge side radially reduced tube 204 are inclinedly arranged (□2 = 30 degrees, □3 = -30 degrees).
In this case, the introduction side radially reduced tube 203 and the discharge side radially reduced tube 204 intersects. The plasma flow P meanders curvedly, and since the droplets D are separated from the plasma flow P by this curved meandering, the collection effect of the droplets D at the stepped portion of the radially enlarged tube is strengthened. There is a choice of (9A) and (9B), furthermore there is a choice of (9C) to (9E), so that the variability spreads by the combination of both. In addition, when there are three or more radially enlarged tubes, the variability increases still more, but the basis of selection is that the droplet collecting efficiency is maximized and the fall of the plasma transporting efficiency is suppressed at largest. If the present invention is used, it becomes possible to spread the width of choice variously.

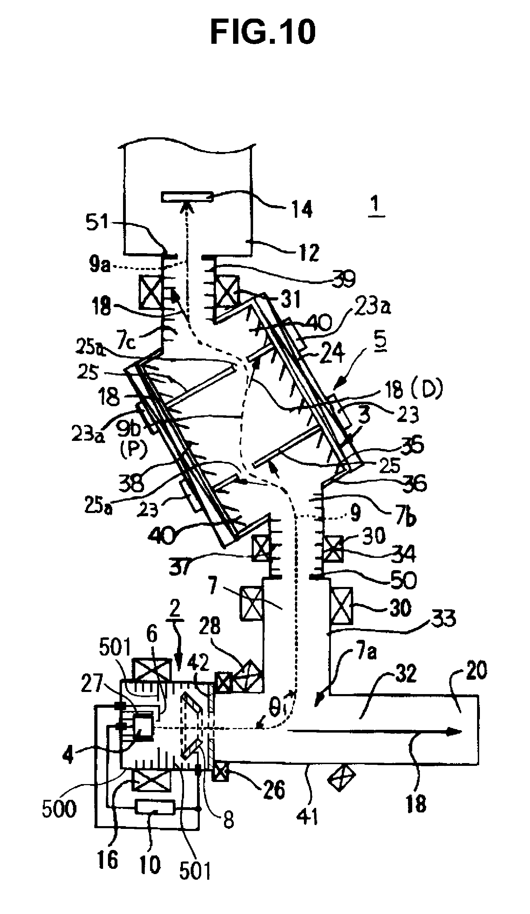

FIG.10 is the outlined schematic diagram of another example of the plasma generating apparatus according to the present invention. The same numeral is used for the same portion as FIG.3, and its description is omitted because its operation and effect are the same. In the following, the operation and effect are described in details for the different numeral. As shown in FIG.10, in the radially enlarged tube 3, two apertures 25 having the passage hole 25a at the eccentric position are disposed in front and back. If it is explained by an outline, when the plasma flow passes through the eccentric passage hole 25a while meandering through the radially enlarged tube 3, the droplets 18 (written as D) are separated and removed from the plasma flow 9b (written as P). That is to say, when the plasma P passes curvedly through the eccentric passage hole 25a of the aperture 25, the small droplets D accompanied with the plasma P jump out outside and are removed by colliding with the wall surface of the aperture 25. In addition, all of the straightly advancing tube 41, the connection advancing path 7, the introduction side radially reduced tube 34, the radially enlarged tube 3 and the discharge side radially reduced tube 39 that constitute the plasma advancing path is held at the electrically neutral floating state.

The slant magnetic field generator is constituted from the straightly advancing magnetic field generator 24 disposed on the outer circumferential surface of the radially enlarged tube 3 and the radial direction magnetic field generator 23, 23a arranged on this circumference. The slant magnetic field is formed by the synthesization between the straightly advancing magnetic field and the radial direction magnetic field, and the plasma P progresses curvedly through the eccentric passage hole 25a of the aperture 25 while being guided by this slant magnetic field.

In FIG. 10, the eccentric passage hole 25a is formed at the left side in the initial end side aperture 25, and the eccentric passage hole 25a is formed at the right side in the final end side aperture 25. Additionally, in the radial direction magnetic field generator 23 of the initial end side, N-pole and S-pole are disposed at the right side and the left side of the figure, respectively, and in the radial direction magnetic field generator of the final end side, N-pole and S-pole are disposed at the left side and the right side of the figure, respectively. Therefore, the radial direction magnetic field from the right side to the left side is formed at the initial end side of the radially enlarged tube 3, and the radial direction magnetic field from the left side to the right side is formed at the final end side. By the synthesization of the radial direction magnetic field and the straightly advancing magnetic field due to the straightly advancing magnetic field generator 24, the slant magnetic field to a little left direction occurs at the initial end side of the radially enlarged tube 3, and the slant magnetic field to a little right direction occurs at the final end side. The plasma P is guided by the slant magnetic field to a little left direction at the initial end side of the radially enlarged tube 3 and curved in the left direction, so that the plasma passes the eccentric passage hole 25a of the initial end side aperture 25. The plasma P is guided by the slant magnetic field to a little right direction at the final end side and curved in the right direction, so that the plasma passes the eccentric passage hole 25a of the final end side aperture 25.

Small droplets D accompanied with the plasma P jump out outside by the bending of the plasma P, and are removed by colliding with the wall surface of the initial end side aperture 25 and the final end side aperture 25. Therefore, the surface of the object to be treated in the plasma processing portion 12 can be treated by the high purity plasma not including the droplets. In addition, in the discharge side radially reduced tube 39, the third magnetic field generator 31 is disposed to advance the plasma 9a toward the plasma processing portion 12.

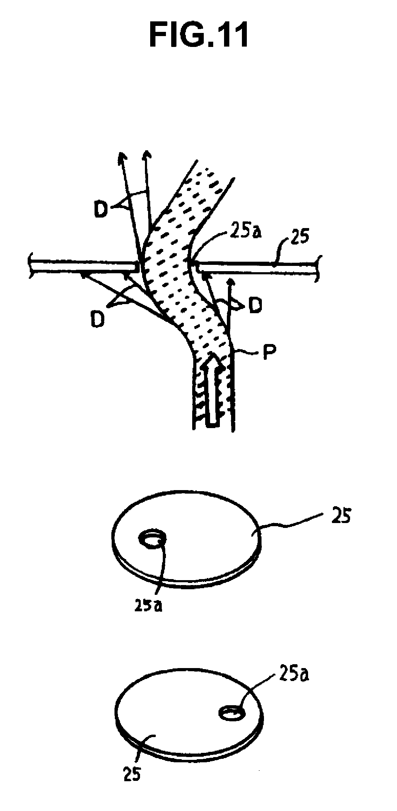

FIG.11 is the explanation diagram showing the state in which the plasma passes through the eccentric passage hole of the aperture disposed in the radially enlarged tube. As illustrated, when the plasma P passes curvedly through the eccentric passage hole 25a of the aperture 25 disposed in the radially enlarged tube 3, the small droplets D accompanied with this plasma P jump out outside at the bending time of the plasma P. The small droplets D jumping out to the initial end side are removed by colliding with the wall surface of the aperture 25. The small droplets D jumping out to the final end side are removed by colliding with the wall surface of the final end side aperture 25 not illustrated.

It is needless to say that the present invention is not limited to the above-described embodiments and modifications; various modifications and design changes, etc. are included in the scope of the present invention within the limits which do not deviate from the technical spirit of the present invention.

### INDUSTRIAL APPLICABILITY

The plasma generating apparatus of the present invention arranges the droplet removing portion in proximity to the plasma gun at the periphery of cathode, so that the uniform plasma flow with high purity can be guided to the plasma treating portion. In addition, when it is used the high purity plasma that is generated by the plasma generating apparatus of the present invention, the high purity thin film hardly including defects and impurities is formed on the surface of solid material in plasma and the uniform modification of the surface characteristics of solid can be performed without giving the defects and impurities by irradiating said plasma, by way of example only, the abrasion resistance, corrosion resistance reinforcement film, protective film, optics thin film and transparent conductivity film of the solid surface can be formed with high quality and high precision.

## Claims

1. In a plasma generating apparatus including a plasma generating portion by which a plasma is generated by a vacuum arc discharge occurred between a cathode and an anode under a vacuum atmosphere and a plasma advancing path in which said plasma generated by said plasma generating portion progresses to a plasma treating portion side, said plasma generating apparatus **characterized in that** an enclosure member surrounding the periphery of said cathode is arranged in said plasma generating portion, a collecting member catching cathode material particles (referred to as droplets) by-produced from said cathode at a plasma generating time is disposed on the inside of said enclosure member, and at least said collecting member and said enclosure member are held in an electrically neutral floating state.

2. The plasma generating apparatus according to Claim 1, wherein a plurality of said collecting members are disposed in multilayer on the inside of said enclosure member around said cathode and along a progressing direction of said plasma.

3. The plasma generating apparatus according to Claim 2, wherein said collecting member is constituted by an annular member in which a hollow portion is formed to flow said plasma, and a plurality of said annular members of the same shape are disposed in multilayer.

4. The plasma generating apparatus according to Claim 2, wherein a plurality of said collecting members include the annular members of which size of said hollow portion is different and a plurality of said annular members are disposed in multilayer so as that the size of each hollow portion increases gradually.

5. The plasma generating apparatus according to any one of Claims 1 to 4, wherein a duct portion forming said plasma advancing path is set to be in the electrically neutral floating state.

6. The plasma generating apparatus according to any one of Claims 1 to 5, wherein said anode is an annular electrode disposed to be electrically insulated from said enclosure member and an inner diameter of said annular electrode decreases along an advancing direction of plasma.

7. The plasma generating apparatus according to any one of Claims 1 to 6, wherein a droplet removing portion removing said droplets is disposed in said plasma advancing path, and said plasma removing portion includes a radially enlarged tube, an introduction side radially reduced tube connected to a plasma introducing side initial end of said radially enlarged tube, a discharge side radially reduced tube connected to a plasma discharge side terminal end of said radially enlarged tube, and stepped portions formed at said initial end and said terminal end of said radially enlarged tube.

8. The plasma generating apparatus according to Claim 7, wherein tube axes of said introduction side radially reduced tube and/or said discharge side radially reduced tube are inclinedly disposed for a tube axis of said radially enlarged tube, and said introduction side radially reduced tube and/or said discharge side radially reduced tube are connected to said radially enlarged tube.

9. The plasma generating apparatus according to Claim 7 or 8, wherein said tube axes of said introduction side radially reduced tube and said discharge side radially reduced tube are disposed so as to intersect each other.

10. The plasma generating apparatus according to Claim 7, 8 or 9, wherein said plasma advancing path includes a straightly advancing tube connected to said plasma generating portion, said introduction side radially reduced tube is connected vertically or almost vertically to said straightly advancing tube, and a droplet collecting portion is disposed at a terminal end of said straightly advancing tube.

11. The plasma generating apparatus according to any one of Claims 7 to 10, wherein said radially enlarged tube is composed of an inner circumferential tube and an outer circumferential tube, and said inner circumferential tube is freely inserted to and removed from said outer circumferential tube.

12. The plasma generating apparatus according to Claim 11, wherein a plurality of droplet collecting plates are installed on an inner wall of said inner circumferential tube.

13. The plasma generating apparatus according to Claim 12, wherein a rough surface processing is made on a surface of said droplet collecting plate.

14. The plasma generating apparatus according to Claim 12, wherein said droplet collecting plates are inclinedly disposed for said introduction side radially reduced tube.

15. The plasma generating apparatus according to any one of Claims 7 to 14, wherein an aperture for collecting the droplets is arranged in said introduction side radially reduced tube and said discharge side radially reduced tube.

16. The plasma generating apparatus according to any one of Claims 7 to 15, wherein a plurality of said radially enlarged tubes are connected through a radially reduced tube.

17. The plasma generating apparatus according to any one of Claims 7 to 16, wherein said introduction side radially reduced tube, said radially enlarged tube and said discharge side radially reduced tube are electrically insulated with said plasma generating portion and said plasma treating portion.

18. The plasma generating apparatus according to any one of Claims 7 to 17, wherein a quantity of physical property of plasma is measured by inserting a probe into a duct portion including at least said introduction side radially reduced tube, said radially enlarged tube and said discharge side radially reduced tube or by utilizing said duct portion as said probe.

19. The plasma generating apparatus according to any one of Claims 1 to 18, wherein one or combination of effective total length, diameter, bending number and summation of bending angle in said plasma advancing path is set so as to satisfy a droplet reduction condition.

20. The plasma generating apparatus according to Claim 19, wherein said effective total length is set at 1600 - 900 mm.

21. The plasma generating apparatus according to Claim 19, wherein said diameter is set at 200 - 90 mm.

22. The plasma generating apparatus according to Claim 19, wherein said bending number is set at 3 - 1.

23. The plasma generating apparatus according to Claim 19, wherein said summation of bending angle is set at 150 - 90°.

24. The plasma generating apparatus according to any one of Claims 1 to 23, wherein an arc current value in said plasma generating portion is adjusted in a range of 140 - 30 A.
